# EUROPEAN PATENT APPLICATION

(11) **EP 3 838 400 A1**
(43) Date of publication of application: **23.06.2021**
(21) Application number: 19217049.6
(22) Date of filing: 17.12.2019
(51) Int. Cl.: B01J 20/22, B01J 20/26, B01J 20/30, H01L 31/04

(54) **PEROVSKITE SOLAR CELL PROVIDED WITH AN ADSORBENT MATERIAL FOR ADSORBING TOXIC MATERIALS**

(71) Applicant: Ecole Polytechnique Federale De Lausanne (EPFL) EPFL-TTO, 1015 Lausanne (CH)
(72) Inventor: HUCKABA, Aron, 1950 Sion (CH); SUTANDO, Albertus Adrian, ID - 50177 Semarang (ID); NAZEERUDDIN, Mohammad Khaja, 1024 Ecublens (CH); QUEEN, Wendy Lee, 1971 Champlan (CH); SUN, Daniel Teav, 1950 Sion (CH)
(74) Representative: Omnis-IP

(57) **Abstract**

The present invention concerns a perovskite solar cell provided with a polymer-porous template composite material for absorbing toxic metal ions. Preferably, the porous template material is a metal oxide framework (MOF) material. An example of a preferred polymer-porous template composite material is PDA-Fe-BTC (polydopamine-Fe1,3,5-benzenetricarboxylate). In experiments mimicking breakage of the solar cell modules, the presence of the polymer-MOF material was shown to result in the capture of lead and thus to reduced leakage of lead.

## Description

### Technical Field

The present invention relates to a solar cell module comprising a toxic material, wherein said module is provided with an adsorbent material. The invention also relates to the use of the adsorbent materials for preventing and/or reducing the leakage of toxic materials from solar cells comprising such toxic materials. The invention also relates to methods for producing solar cells and in particular modules comprising such solar cells.

### Background Art and Problems Solved by the Invention

The efficiency of perovskite solar cells has dramatically increased from 3.2% in 2009¹ to >25% ten years later,² however, perovskite solar cells are inherently unstable to oxygen and moisture,³ which makes the potential end-of-life environmental impact of installing perovskite solar modules at large scale a serious concern.⁴ Several recent life cycle assessments have concluded that even with the health concerns,⁵⁻⁷ Pb containing PV poses much less risk to the environment than coal power plants.^{4,8-10} Nevertheless, waste regulations in the EU and China deem producers liable for downstream environmental and health effects, which should signal to the community that developing a "Safe-by-Design" (SbD) approach is not only legally useful, but ethically responsible.¹¹ In recent years, a number of publications have detailed the recycling and/or reuse of perovskite solar cells components,^{4,12-14} or the protection of the perovskite layer from water,^{15,16} but so far none have detailed the adsorption of Pb that results from degraded devices.

It is an objective of the invention to provide solutions for reducing the risk of leakage of toxic metals from perovskite solar cells and/or from modules comprising such solar cells, for example due to breakage of the module and/or the solar cells. Leakage may occur also for other reasons, for example wear, tear and/or leakage occurring with time, due to exposure to environmental conditions for a prolonged time. Leakage may occur, for example, if the materials of the solar cell and/or the module comprising the solar cells to lose their properties with time, such as sealants getting brittle and the like.

WO 2019/038645 discloses similar and further polymer-metal-organic framework (MOF) composite material, which were shown to be useful for extracting metals from water. For example, the polymer-MOFs, such as Fe-BTC/PpPDA (BTC = 1,3,5-benzenetricarboxylate; PpPDA = poly-para-phenylenediamine), was found useful for recovering gold from sea water. Similarly, D. Sun et al, "Rapid, Selective Heavy Metal Removal from Water by a Metal-Organic Framework/Polydopamine Composite" ACS Cent. Sci. 2018, 4, 3, 349-356, reported a polymer-metal-organic framework (MOF) composite materials.¹⁷

### Summary of the Invention

Remarkably, the present inventors provide solutions with respect to preventing leakage of toxic metals comprised in certain optoelectronic devices, such as perovskite solar cells.

In an aspect, the invention provides a solar cell module comprising one or more solar cells comprising a toxic material, wherein said module is provided with an adsorbent material.

In an aspect, the invention provides a solar cell panel comprising a casing, one or more solar cells provided in said casing, and an adsorbent material. Preferably, said adsorbent material is also comprised in said casing.

In an aspect, the invention provides a solar cell module comprising one or more solar cells organic-lead perovskite solar cells, wherein said module is provided with a Metal Organic Framework (MOF)/polymer composite material, wherein said composite material is preferably provided so as to trap or capture lead in case of damage of the solar cell and/or in case of leakiness of said module with respect to the environment.

In an aspect, the invention provides a method for producing a solar cell module comprising one or more solar cells comprising a toxic material, wherein said method comprises providing an adsorbent material when assembling said solar cell module.

In an aspect, the invention provides the use of an adsorbent material, in particular a MOF/polymer composite material, for preventing and/or reducing leakage of toxic materials from solar cells comprising such toxic materials.

In an aspect, the invention provides the use of an adsorbent material, for example a MOF/polymer composite material, for capturing toxic materials, such as metals, from solar cells comprised of such toxic materials in case of damage to such cells, damage to panels and/or modules comprising such cells, and/or in case of leakiness of devices comprising such solar cells.

Further aspects and preferred embodiments of the invention are defined herein below and in the appended claims. Further features and advantages of the invention will become apparent to the skilled person from the description of the preferred embodiments given below.

### Brief Description of the Drawings

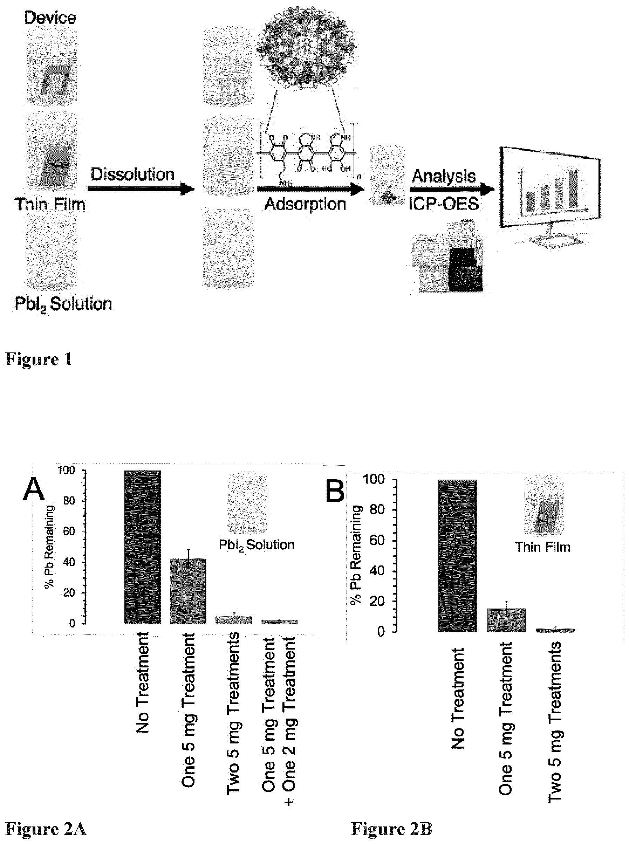

**Figure 1** illustrates the workflow of the experiments used in accordance with embodiments of the invention.

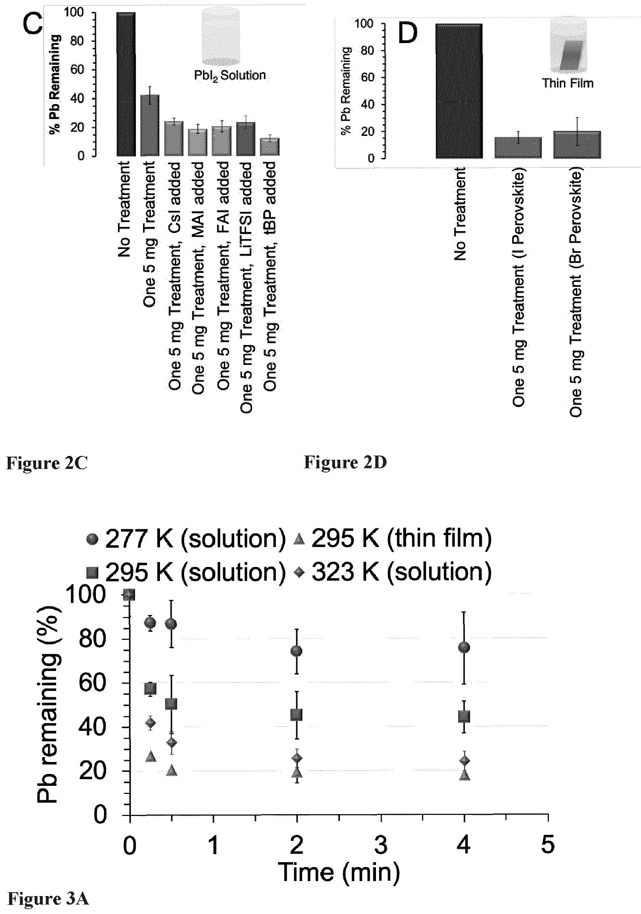

**Figures 2A-3D** show results of Pb uptake from various solutions in accordance with embodiments of the invention. Fig. 2A: Pb uptake of aqueous PbI₂ solutions with various treatments after 3h at 50°C. Fig. 2B: Pb uptake from perovskite solar cell absorber layers in 323 K water with various treatments of material after 3h. Fig. 2C: Pb uptake by polymer-MOF composite of aqueous PbI₂ solutions with various additives after 3h at 323 K. The molar quantity of additive matched the stoichiometry found in the perovskite absorber thin film precursor solution. Fig. 2D: Pb uptake by 5 mg polymer-MOF composite of solutions derived from PbI₂ (red) or PbBr2 (blue) based perovskite films after 5 min at 295K. Each plotted point is the average of three replicate experimental data points and each experimental data point is the average of three replicate measurements. Error bars are included for each plotted point and represent one standard deviation.

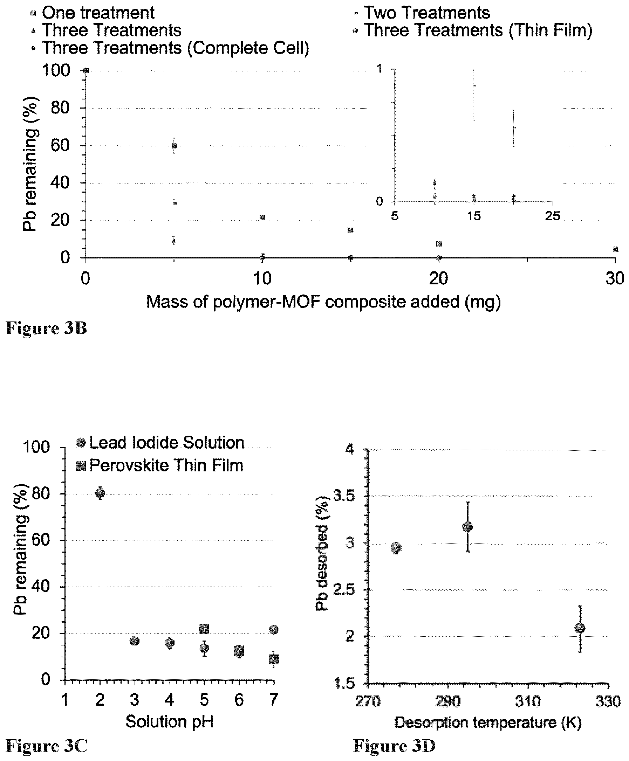

**Figures 3A-3D** show results of experiments assessing the kinetics of Pb uptake in accordance with embodiments of the invention. Fig. 3A: Pb uptake of aqueous PbI₂ solutions and [(FAPbI₃)_{0.87}(MAPbBr₃)_{0.13}]_{0.92}(CsPbI₃)_{0.08} perovskite thin film absorber with single treatments of 5 mg of polymer-MOF composite after various time points and at various temperatures. Fig. 3B: Pb uptake study of aqueous PbI₂ solutions with varying mass and number of treatments, perovskite thin film, and completed perovskite solar cell of the polymer-MOF composite after 5 min at 295K and minimal solution agitation. *Inset:* Zoomed in version of the same data, from 0-2% Pb remaining. Fig. 3C: Pb uptake study of aqueous PbI₂ solutions with varying solution pH after 5 min at 295K and one treatment of 10 mg with either PbI₂ solutions or solutions deriving from perovskite thin films. Fig. 3D: Pb desorption study performed in DI water (5 mL) at variable temperature for 2h after using one 15 mg treatment for 5m. Each plotted point is the average of three experimental data points and each experimental data point is the average of three replicate measurements. Error bars are included for each plotted point and represent one standard deviation.

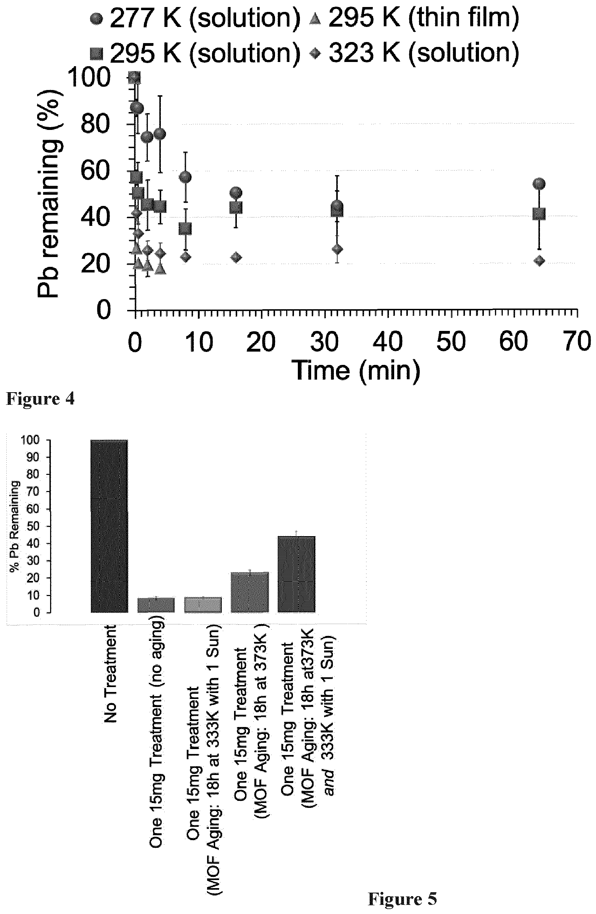

**Figure 4** shows Pb uptake of aqueous PbI₂ solutions (squares (295 K), diamonds (323 K), circles (277 K)) and [(FAPbI₃)_{0.87}(MAPbBr₃)_{0.13}]_{0.92}(CsPbI₃)_{0.08} perovskite thin film absorber (triangles (295K)) with single treatments of 5 mg of polymer-MOF composite after various time points and at various temperatures. Each plotted point is the average of three replicate experimental data points and each experimental data point is the average of three replicate measurements. Error bars are included for each plotted point and represent one standard deviation.
**Figure 5** shows the effect of various aging treatments on Pb absorption. Treatments are as shown in the figure. Accelerated aging study performed in DI water (5 mL) at 395K after using one 15 mg treatment of PDA-MOF composite for 5 min. Each plotted point is the average of three replicate experimental data points and each experimental data point is the average of three replicate measurements. Error bars are included for each plotted point and represent one standard deviation.

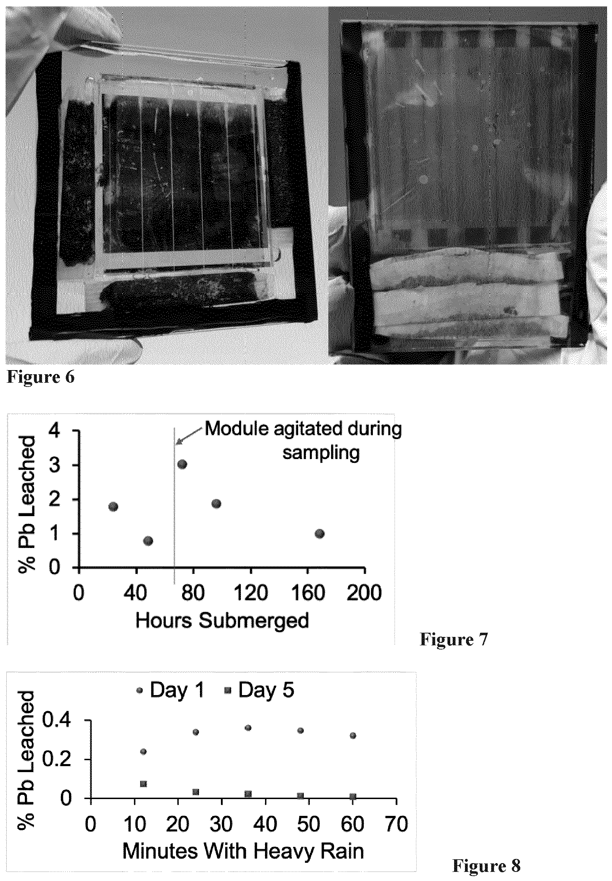

**Figure 6** are photographs of modules according to the invention tested under particular conditions: *Left:* Fully submerged inside an encapsulating glass case with three 300 mg MOF treatments, *Right:* Module encapsulated on the top and sides, allowing water to pass from the top over the module and through the three 300 mg MOF treatments before exiting the glass case.
**Figure 7** shows Pb leached from a submerged monolithic series cell module. Three 300 mg treatments were placed around the module and the module was encapsulated on three sides (top open) and the Pb concentration sampled once per day up to 7 days after the start of the experiment. Module was kept at room temperature with little agitation. In the course of sampling at the 72h time point, the submerged module was accidentally agitated when the module was dropped from a height of six centimeters. The solution remained inside the module, but the mixing was evident. Percentage reflect lead measured in solution at various moments in time with respect to the total amount of lead contained in the solar cell module.
**Figure 8** shows Pb contained in water that was flowed through a damaged solar cell module. Flow-through module Pb leaching study using 45.5 cm² substrate (39 cm² perovskite absorber) and simulated 1h moderate rainfall for the day of module construction (*gray circles*), and simulated 1h moderate rainfall for the fifth day after module construction (*red squares*).

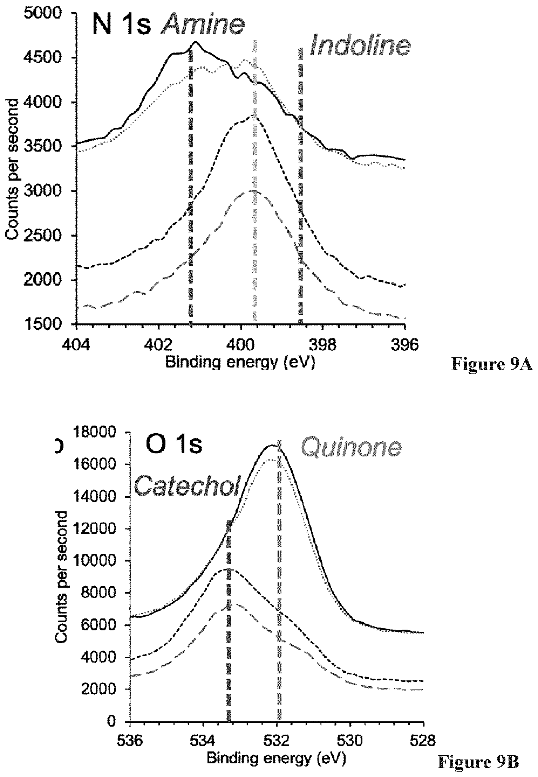

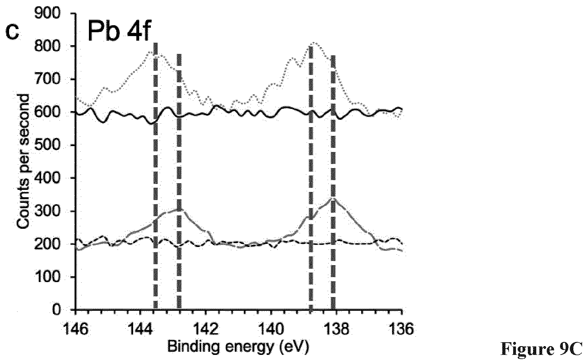

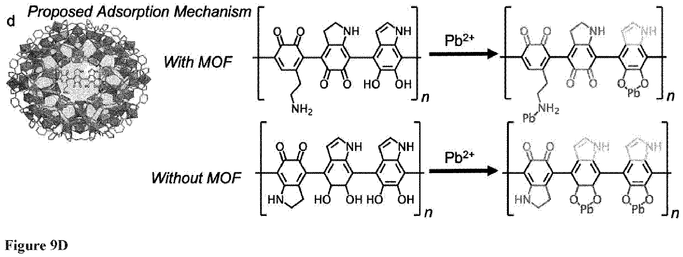

**Figure 9** shows results and conclusions for identified moieties of the polymer of the polymer-MOF that are responsible for Pb adsorption. Fig. 9A: XPS analysis of the N 1s region for MOF/polymer without (black straight line), with (red dotted line) adsorbed Pb, and then just the polymer with (red, long dashes), and without (black, short dashes) adsorbed Pb. Fig. 9B: XPS analysis of the O 1s region for MOF/polymer without (black straight) and with (red, dotted) adsorbed Pb, and just the polymer with (red, short dashes), and without (black, long dashes) adsorbed Pb. Fig. 9C: XPS analysis of the Pb 4f characteristic for MOF/polymer without (black straight) and with (red dotted) adsorbed Pb, and then just the polymer with (red, long dashes), and without (black, short dashes) adsorbed Pb. Fig. 9D: Proposed adsorption mechanism showing representative chelating moieties for polymer and MOF/polymer composite.

Hereinafter, preferred embodiments of the device of the invention are described, in order to illustrate the invention, without any intention to limit the scope of the present invention.

### Detailed Description of the Preferred Embodiments

The present invention relates to optoelectronic and/or photoelectronic devices comprising toxic materials and to the prevention or reduction of leakage from such toxic materials from the devices. In a preferred embodiment, the optoelectronic device is a solar cell, preferably a perovskite solar cell. The solar cell is preferably an organic-inorganic perovskite solar cell. In an embodiment, the perovskite solar cell comprises lead.

Methods for producing organic-inorganic perovskites and solar cells containing such perovskites are widely described in the state of the art.

In perovskite solar cells, the perovskite generally fulfils the purpose of the generation of an exited electron upon light absorption, wherein the electron will be transported to the front and/or rear contact of the solar cell and thus contributes to the generation of the photovoltage by the solar cell.

The inorganic component of such perovskites is generally a metal, such as lead (Pb), tin (Sb), copper (Cu), bismuth (Bi), antimony (Sb), palladium (Pd), or any other alkali metal, metal, metalloid, or semi-metal with a positive or doubly positive charge, with Pb being used more widely. Lead is a heavy metal known to be toxic, acting, for example as a neurotoxin that accumulates in soft tissues and bones, interferes with the function of enzymes and may cause neurological disorders. In an embodiment, said toxic material is a toxic metal. In an embodiment, the toxic material is selected from lead and tin, but may also encompass other toxic metals. In a preferred embodiment, said toxic material is a toxic metal ion, in particular a lead-ion.

In an embodiment, the invention relates to a module comprising one or more solar cells. The module may, for example, comprise one or more solar cells as components of the overall module. The solar cell module may be provided in the form of a solar cell panel.

Preferably, the components of the solar cell, in particular the components comprising toxic materials, such as the lead-organic-perovskite, and optionally other components, such as hole transport materials, additives and the like, are sealed in the inside of the solar cell or inside the module. The solar cell or the module thus preferably comprises components forming a substrate of the solar cell. For example, transparent conductive glass or plastic may be provided on one side of the solar cells, forming a current collector and at the same time a substrate and/or delimitation on one side of the solar cell. Transparent conductive glass or plastic may be coated with transparent metal oxide conductive materials, such as indium doped tin oxide (ITO), fluorine doped tin oxide (FTO), ZnO-Ga₂O₃, ZnO-Al₂O₃, tin oxide, antimony doped tin oxide (ATO), SrGeO₃ and zinc oxide, or combinations thereof. Any kind of panel, glass, plastic and the like may be provided to close the solar cell or module on the other side. In some instances, a cathode material directly forms the closure of the cell on the other side, generally the rear contact. Generally, the components of the solar cell or solar cell module, in particular the toxic material, is air and/or water tightly enclosed and/or sealed inside the solar cell. Therefore, in normal circumstances, there is only little risk of leakage of the lead or of other components to the outside of the solar cell.

Leakage of toxic materials may occur, for example, in case of damage to the solar cell and/or module and/or to the casing comprising the solar cell. Damage may occur due to impacts and/or due to material abrasion, material failure, production faults, or simply due to loss of the functionality of the components of the solar cell with time, for example due to continued exposure to oxygen, environmental conditions, such as rain, temperature fluctuations and the like, for example. In any event, damage of the solar cell or the module containing the cell cannot be excluded totally.

In order to reduce the amount of leaked toxic material and in particular of lead especially into the environment, the module and/or solar cell of the invention is preferably provided with an adsorbent material. The adsorbent material is preferably comprised in or in vicinity of the module comprising the solar cell.

In a preferred embodiment, said adsorbent material is provided for capturing said toxic material in case of leakage of components of the solar cell out of said module and/or solar cell.

In a preferred embodiment, solar cell module of any one of the preceding claims, wherein said one or more solar cells are provided in said casing. Preferably, said adsorbent material is also provided in said casing.

In an embodiment, the invention provides a solar cell panel comprising a casing, one or more solar cells provided in said casing, and said adsorbent material, wherein said adsorbent material is preferably also comprised in said casing.

Preferably, said solar cell and/or said adsorbent material are provided within said casing.

For example, the adsorbent material may be provided in one or more bags or any kind of water-permeable containers, which water-permeable containers are disposed in said casing.

**Figure 6** shows solar cell modules and permeable bags containing the adsorbent material within a case or casing. Instead of bags, water-permeable boxes, for example comprising on or more meshed walls, or other water-permeable containers may be used. The water-permeable container is preferably used for locally constraining said adsorbent material within the solar cell panel and/or with respect to the solar cell module.

In an embodiment, the module and said adsorbent material are sealed within said case or casing.

In an embodiment, the casing comprises one or more transparent glass or plastic covers or panels. Preferably, the casing may comprise a sealant, such that the solar cell module and the adsorbent material are sealed between two transparent panels or between a transparent (e.g. glass or plastic) panel and a non-transparent panel.

In an embodiment, the adsorbent material is directly integrated in or applied on said module. In this case, a separate casing may be absent. For example, the adsorbent material may be disposed on one or more surfaces of the module, e.g. coated on one or more surfaces of the module.

In an embodiment, the adsorbent material is provided within said casing and/or with respect to the solar cell module at a position which is likely to suffer damage and/or which may serve as a potential leaking point in case of damage to the module.

In an embodiment, the solar cell module and/or the casing containing the module may comprise one or more predetermined breaking points. The one or more predetermined breaking point may be engineered in such a manner that when the casing and/or module is exposed to mechanical stress or impact, a breakage and/or leakage is likely to occur at a predetermined position of the casing and/or module. In this case, the adsorbent materials is preferably disposed in spacial proximity to said predetermined breaking point, for example inside permeable containers such as bags, as a loosely disposed powder or structured pellets or beads, as a coating, or as a combination of two or more of the aforementioned.

In the embodiments shown in Figure 6, bags or other permeable containers comprising an adsorbent material are disposed laterally from the solar cell module (left photograph) and or at the bottom of the module (right photograph) within a casing. The placement of the adsorbent material at the bottom side of the module is appropriate for modules that are intended to be fixed vertically or close to vertically, e.g. at an angle of 0° to 45° with respect to vertical, when in use, for example on walls, windows, balustrades, fences, for example.

In a solar cell module that is intended for horizontal or near to horizontal orientation when in use, for example, at an angle of up to 0° to 45° with respect to horizontal, the adsorbent material may advantageously be placed below the module, preferably on the rear side of the module, that is opposite the light impact side.

The predetermined breaking point, if present, is preferably designed with respect to the intended orientation (vertical or horizontal, for example) of the solar cell panel or module.

In an embodiment, said adsorbent material is porous.

In an embodiment, said adsorbent material is selected from a particulate material, a powdered material, and a film, for example a thin film.

In an embodiment, said adsorbent material is selected from the group consisting of: metal organic frameworks (MOFs), MOF/polymer composites, covalent organic frameworks (COFs), carbon, porous polymers, and combinations comprising one or more of the aforementioned.

Examples of porous polymers of cyclodextrin, cellulose, and tannins. Pourous-β-cyclodextrin polymer is disclosed, for example, in Alsbaiee et al, "Rapid removal of organic micropollutants from water by a porous β-cyclodextrin polymer", Nature, volume 529, pages 190-194 (2016).

Said carbon may be an activated carbon material.

MOFs are also known as porous coordination polymers (PCPs), organic porous materials (MOPMs), porous coordination networks (PCNs), or metal organic materials (MOMs), are a class of crystalline materials having generally infinite network structures built with multitopic organic ligands and metal ions.

In an embodiment, said adsorbent material comprises a Metal Organic Framework/polymer (MOF/polymer) composite material. The MOF/polymer composite material may also be referred to as polymer-MOF in this specification. In this specification, the expressions "composite material" and "composites" are generally meant to refer to said MOF/polymer composites (or composite material).

In an embodiment, wherein the polymer of said MOF/polymer, as applicable, is selected from the group consisting of: redox active polymers, peptides, biopolymer including polypeptides and polysaccharides, epoxy-based polymer, fluoropolymer, acrylics, dedrimers, rubbers, inorganic polymers, organic polymers, and two or more of the aforementioned.

For the purpose of the present specification, the term "polymer" preferably encompasses the situation where two or more, preferably three or more, and most preferably four or more monomeric units are covalently connected. In a preferred embodiment, 5, 6, 7, 8 and 10 or more monomeric units are connected so as to form a polymer. For the purpose of the present specification, polymer encompasses oligomers and reference to polymer encompasses a reference to a corresponding oligomer.

In a preferred embodiment, the polymer of said MOF/polymer are organic polymers.

In an embodiment, said polymer of said composite material comprises one or more of the following chemical functions: alcohol/hydroxyl, catechol, and/or primary, secondary or tertiary amine, amide, nitrile, pyridine, pyrrole, thiol, thiolether, thiophene, thiadiazole, phenol, pyragallol, carboxylic acid, ester, acyl, crown ether, phosphate, phosphoryl, epoxide, halogen, haloalkane.

In a preferred embodiment, said polymer said composite material comprises one or more of the following chemical functions: alcohol/hydroxyl, catechol and primary amine.

In an embodiment of the solar cell module of the invention, the polymer of said MOF/polymer comprises and/or is formed from one or more moieties, which are independently selected from moieties of formula (I): 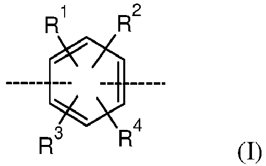 wherein,
the dotted lines in formula (I) represent the two single bonds by which the moiety of formula (I) is connected to a neighbouring moiety of the polymer;
R¹, R², R³ and R³ are independently selected from H, -OH, -NH₂, -NO₂, -COH, -COOH, -CN, from substituents of formula (V) and (VI): 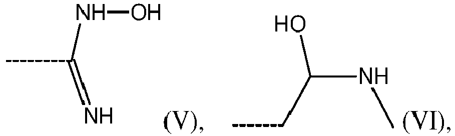
   and from organic substituents comprising from 1 to 20 carbons and 0 to 20 heteroatoms selected from O, N, S, P and halogen;
   wherein two or three of R¹, R², R³ and R³ may be connected with each other so as to form a ring or ring system fused to the benzene ring of formula (I), said ring or ring system comprising from 2-30 carbons and 0 to 30 heteroatoms;
   with the proviso that one or more selected from R¹, R², R³ and R³ are independently selected from substituents of formula (II): 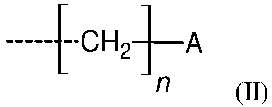 wherein:
      the dotted lines in formulae (II), (V) and (VI) represent the single bond by which the respective substituent of formula (II), (V) and/or (VI) is connected to the benzene ring of formula (I),
      A is independently selected from -OH, -NH₂, and -SH,
      n is 0 or an integer of 1-10.

Preferably, n is 0 or an integer of 1-5, more preferably 1-3.

Preferably, A is independently selected from -OH and -NH₂.

In an embodiment, said organic substituents are selected from C1-C20 alkyl, C2-C20 alkenyls, C2-C20 alkynyls, C1-C20 alkoxyl, C1-C20 thioalkyl, C6-C20 aryls and/or C4-C20 heteroaryls, optionally further substituted with one or more further substituents selected independently from the group consisting of: -OH, =O, -COOH, -NH2, -SH, amidoximyl, C1-C10 alkyl, C1-C10 alkoxyl, and C1-C10 thioalkyl.

The carbons and heteroatoms of said further substituents are included in the number of 1-20 carbons and 0-20 heteroatoms indicated with respect to said organic substituent.

In a preferred embodiment, said organic substituents comprise from 1 to 10 carbons and 0 to 10 heteroatoms, preferably 1 to 5 carbons and 0 to 4 heteroatoms selected from O, N, S, P and halogen. In a preferred embodiment, said organic substituents are selected from C1-C10 alkyl, alkenyls, alkynyls, C1-C10 alkoxyl, C1-C10 thioalkyl, C6-C10 aryls and/or C4-C10 heteroaryls, optionally substituted with one or more selected independently form -OH, -NH₂,-SH, C1-C6 alkyl, C1-C6 alkoxyl and C1-C6 thioalkyl.

In an embodiment, said ring or ring system fused to the benzene ring of formula (I), comprises from 2-15 carbons and 0 to 10 heteroatoms, including ring heteroatoms selected from O, N and S. In a preferred embodiment, said ring or ring system comprises 2-10 carbons and 0-5 heteroatoms, more preferably 2-6 carbons and 0-3 heteroatoms.

Said ring or ring system may comprise further substituents preferably selected from -OH, - NH2, -SH, halogen, C1-C10 alkyl, C1-C10 alkoxyl, and C1-C10 thioalkyl, wherein carbons and heteroatoms of said further substituents are included in the number of carbons and heteroatoms indicated above with respect to the ring or ring system.

In an embodiment, the polymer of said MOF/polymer comprises one or more moieties, which are independently selected from moieties of formula (III): 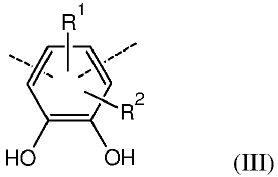 wherein: said dotted lines, R¹ and R² are independently defined as above, including the embodiments of formula (II) and preferred embodiments thereof.

In an embodiment, the polymer of said MOF/polymer comprises one or more moieties, which are independently selected from moieties of formula (IV): 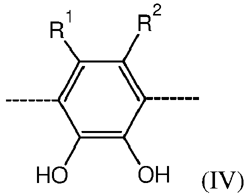 wherein: said dotted lines, R¹ and R² are independently defined as above, including the embodiments of formula (II) and preferred embodiments thereof.

In an embodiment, the polymer comprises and/or is formed from one or more of the following monomeric moieties: dopamine (DA), serotonin (S), 2-aminophenol (oAP), 3-aminophenol (mAP), 4-aminophenol (pAP), p-phenylenediamine (pPDA), o-phenylenediamine (oPDA), 3,4-dihydroxybenzoic acid (3,4-DHBA), 3,4-dihydroxyphenylacetic acid (3,4-DHPAA), 3,4-dihydroxyhydrocinnamic acid (3,4-DHHCA), 3,4-dihydroxybenzonitrile (3,4-DHBN), 4-nitrocatechol (3-NC), 3,4-dihydroxybenzaldehyde(3,4-DHBAH), 2,3,5-trihydrixybenzaldehyde (2,3,5-THBA), 217 3,4-dihydroxybenzylamine (3,4-DHBAM), 3,4-dihydroxybenzamidoxime (3,4-DHBAMX), (+)epinephrine (Adrenaline), Tetracyanoquinodimethane (TCNQ), viologens, Tetrathiafulvalene (TTF), quinone (Q), hydroquinone (HQ), tyramine (TA), vinylferrocene (VF or VFc), perfluorinated Sulfonic acids (Nafion®), styrene sulfonate (SS), 4-vinylpyridine (VP), aniline (ANI), aniline derivatives, 1 -aminoanthracene, o-toluidine, 1 ,8-diaminonaphthalene (DAN), aniline-co-N-propanesulfonic acid-aniline, diphenylamine (DPA), 2-aminodiphenylamine (2ADPA), luminol (L), pyrrole (P) and P derivatives, indole and derivatives, melatonin (M), indoline, carbazole (Cz), thiophene (T) and T derivatives, azines, 1 -Hydroxyphenazine (PhOH), acridine red (AR), phenosafranin (PhS), flavin (FI), new Fuchsin (nF), fluorene (F), 9-Fluorenone (FO), 9,10-dihydrophenanthrene, p-phenylene (PP), phenylenevinylene (PPV), triphenylamine (TPA), 4-vinyl-triphenylamine (VTPA), polyrhodanine (Rh), Eriochrome Black T, 5-amino-1,4-naphthoquinone (ANQ), 5-amino-1-naphthol, 4-ferrocenylmethylidene-4H-cyclopenta-[2,1-b;3,4-b°]-dithiophene, fullerene-functionalized terthiophene (TTh-BB), tetra-substituted porphyrins, phtalocyanines, tetra-substituted-phtalocyanines, 4,4°(5°)-bis(3,4-ethylenedioxy)thien-2-yl, tetrathiafulvalene (EDOT-TTF), {3-[7-Oxa-8-(4-tetrathiafulvalenyl) octyl]-2,2°-bithiophene} (T-TTF), aniline-co-diaminodiphenyl sulfone, aniline-co-2,3-amino or 2,5-diamino benzenesulfonic acid, aniline-co-o-aminophenol, m-toluidine-co-o-phenylenediamine, luminol-aniline, and 2,5-dihydroxy- 1,4-benzenediacetic acid (DHAA).

The polymers obtained in said MOF/polymer using the above monomers may be directly derived from the monomers. For example, the polymer obtained using dopamine is polydopamine (PDA), the polymer of serotonin is polyserotonin (PS), and so forth.

In an embodiment, the polymer of said MOF/polymer is selected from the polymers mentioned above, which comprise a primary amino group.

In an embodiment, the polymer of said MOF/polymer is selected from the group consisting of: polydopamine (PDA), polyquinone (PQ), polyhydroquinone (PHQ), polytyramine (PTA), poly(o-aminophenol) (PoAP), polymelatonin (PM), polyhydroxyphenazine (PPhOH), poly(aniline-co-o-aminophenol), polymer of 2,5-dihydroxy- 1,4-benzenediacetic acid (PDHAA), poly-para-phenylenediamine (PpPDA). The aforementioned polymers preferably comprise one or more free hydroxy groups.

In an embodiment, the polymer of said adsorbent material is selected from the group consisting of: polydopamine (PDA), polytyramine (PTA), poly(o-Aminophenol) (POAP), poly(aniline-co-o-aminophenol), polymer of 2,5-dihydroxy- 1,4-benzenediacetic acid (PDHAA), poly-para-phenylenediamine (PpPDA,), preferably among polydopamine (PDA) and polytyramine (PTA). The aforementioned polymers preferably comprise one or more free hydroxy and one or more primary amino groups.

In an embodiment, the polymer of said composite material is selected from the group consisting of: PDA, PS, PpAP, PoAP, PmAP, PpPDA, P-3,4-DHBA, P-3,4-DHPAA, P-3,4-DHHCA, P-3,4,-DHBN, P-4-NC, P-3,4-DHBAH, P-2,3,5-THBA, P-3,4-DHBAM, P-3,4-DHBAMX, P-Adrenaline.

In a preferred embodiment, said polymer is polydopamine (PDA).

In a preferred embodiment, said metal organic frameworks (MOFs) comprises Fe-BTC (BTC = 1,3,5-benzenetricarboxylate), Cu-BTC, Cu-TDPAT (TPDAT = 2,4,6-tris(3,5-dicarboxylphenylamino)-1,3,5-triazine, or Al-BDC-NH2 (BDC = 2-amino-1,4-benzenedicarboxylate), preferably Fe-BTC or Cu-BTC.

In a preferred embodiment, said polymer-porous template composite material is selected from the group consisting of: Fe-BTC/PS, Fe-BTC/PpAP, Fe-BTC/PoAP, Fe-BTC/PmAP, Zr-BDPC/PpPDA, Al-BDC-NH2/PpPDA, Cu-TDPAT/PpPDA, Zr-(tetrakis(4-carboxyphenyl)porphyrin (H2TCPP) and [M-5,10,15,20-tetrakis(4-carboxyphenyl)porphyrinato] (where M = a transition metal)PpPDA, Fe- 3,3,'5,5'-azobenzenetetracarboxylate)PpPDA, Fe-BTC/P-3,4-DHBA, mFe-BTC/P-3,4-DHPAA, Fe-BTC/P-3,4-DHHCA, Fe-BTC/P-3,4-DHBN, Fe-BTC/P-4-NC, Fe-BTC/P-3,4-DHBAH, Fe-BTC/P-2,3,5-THBA, Fe-BTC/P-3,4-DHBAM, Fe-BTC/P-3,4-DHBAMX, and Fe-BTC/P-Adrenaline.

In a preferred embodiment, said polymer-porous template composite material comprises Fe-BTC/PDA.

Methods for producing polymer-porous template composite materials such as those disclosed herein above are disclosed, for example in WO 2019/038645 and in D. Sun et al, 2018, cited above.

The synthesis of MOFs has been disclosed previously. The following literature references are cited in an exemplary, non-limitative manner for the purpose of illustration only:
FE-BTC: Majano et al., " Room-temperature synthesis of Fe-BTC from layered iron hydroxides: the influence of precursor organisation", CrystEngComm, 2013, 15, 9885-9892. See also: Sun et al, "Rapid, Selective Extraction of Trace Amounts of Gold from Complex Water Mixtures with a Metal-Organic Framework (MOF)/Polymer Composite" J. Am. Chem. Soc. 2018, 140, 16697-16703;
Zr-BDPC: Amani et al, "Interactions of NO2 with Zr-Based MOF: Effects of the Size of Organic Linkers on NO2 Adsorption at Ambient Conditions", Langmuir 2013, 29, 168-174;
Zr-PCN-221: Seong Won Hong et al, " Substrate templated synthesis of single-phase and uniform Zr-porphyrin-based metal-organic frameworks, Inorg. Chem. Front. DOI: 10.1039/c9qi01045 ;
MIL-127 Fe: Chevreau et al., " Synthesis of the biocompatible and highly stable MIL-127IJFe: from large scale synthesis to particle size control", CrystEngComm, 2016, 18, 4094.

A reference disclosing M₂(NDISA)-PDA MOFs is Li et al 2019, J. Am. Chem. Soc. 2019, 141, 12397-12405.

A reference disclosing NH2-MIL-53(Al) is J Serra-Crespo et al. Am. Chem. Soc. 2012, 134, 8314-8317.

A general, exemplary way of producing MOF/polymer is provided as follows for the purpose of illustration only:
Initially, MOF/Polymer composites may be constructed under air free conditions to reduce variables that could affect the performance of the resulting material. First, MOFs were activated under vacuum in a 2-neck round bottom flask connected to a schlenk line and a rough oil pump at a temperature higher than the boiling point of water or solvent. This increases monomer diffusion into the porous networks and removes any solvent or water bound to open metal sites so that they may be used to facilitate the *in-situ* polymerization of the monomers. After activation, usually overnight, the reaction vessel is filled with an inert gas like argon or nitrogen. Next, in a dry box the monomer is mixed with anhydrous alcohol, stirred until dissolved and sealed. Using a steel canula and an inert gas, the solution is transferred to the reaction vessel containing the activated MOF and allowed to stir at room temperature under an inert atmosphere until the polymerization has finished again usually overnight. It should be noted that if the reaction mixture is exposed to air and temperatures are elevated then the polymer wt. percent will increase in the system. Likely, this is due to oxygen oxidizing and regenerating the catalytic open metal site to push the *in-situ* polymerization reaction forward. After reaction completion, the powder now a darker color is separated with centrifugation or vacuum filtration and washed with the solvent used in the reaction. The powder is loaded into a cellulose whatman thimble and undergoes soxhlet purification overnight with the solvent of choice. After purification, the powder is dried under vacuum and is activated at the desired temperature before standard characterization.

**Double Solvent Method.** This method can be utilized if MOFs do not have unsaturated open metal sites that facilitate the *in-situ* polymerization reaction, but also works with MOFs that do have open metal sites. First, a MOF is activated under vacuum in a two-neck round bottom flask using a schlenk line and rough oil pump to remove any polar solvent like water. After dosing an inert gas into the system, anhydrous non-polar hexane is added to the reaction mixture and allowed to stir until complete diffusion usually in less than 30 minutes. The monomer is then dissolved into the most minimal amount of water as possible. This aqueous solution is then syringed into the reaction mixture. Over time, the hydrophilic MOF will mix will the water and work its way to the bottom of the reaction vessel. Once this is achieved, the anhydrous hexane is then decanted out. Now a pH swing is conducted to facilitate the *in-situ* polymerization reaction. An alcohol solution containing a base like ammonia (NH3) is added to the reaction and allowed to stir until reaction completion usually overnight. The solids now a darker color is separated from the solvent either by centrifugation or vacuum filtration and is washed with fresh solvent that is used in the reaction. The powder is loaded into a cellulose whatman thimble and undergoes soxhlet purification overnight. After purification, the powder is dried and activated before standard characterization. A reference disclosing the double solvent method for producing MOF/polymer composites is "MOF/polymer composite synthesized using a double solvent method offers enhanced water and CO2 adsorption properties" L. Peng, S. Yang, D. T. Sun, M. Asgari, W. L. Queen, Chem. Commun. 2018, 54, 10602.

While certain of the preferred embodiments of the present invention have been described and specifically exemplified above, it is not intended that the invention be limited to such embodiments. Various modifications may be made thereto without departing from the scope and spirit of the present invention, as set forth in the following claims. Herein below, examples of the invention are disclosed. These examples are for illustration only and are not intended to limit the scope of the present invention.

### Examples

### Example 1: Suitability of polymer-MOFs for taking up Pb from perovskite solar cells

To adequately simulate the propensity of the polymer-MOF composite to take up Pb from perovskite solar cells, we decided to use a work flow (**Figure 1**) in which first thin films and/or cells were submerged in water until dissolved and then the liquid extract was poured onto the polymer-MOF composite and allowed to react without stirring. Last, analysis by coupled inductively coupled plasma and optical emission spectroscopy (ICP-OES) allowed for quantification of Pb in the liquid samples.

*General Considerations:* All commercial reagents and consumable items were used as received. ICP-OES measurements carried out using an Agilent 5110 ICP-OES. The porous polymer-MOF composite uptake material was synthesized as previously reported. For this example, the MOF/polymer was Fe-BTC/PDA, which was produced as disclosed in WO 2019/038649, pages 31-32. See also Sun et al 2018.

*Thin Film Fabrication:* FTO-coated glass (Nippon Sheet Glass) was patterned by chemical etching with zinc powder and HCl solution. The etched glass substrate was then sonically cleaned with Hellmanex solution, water, acetone, and 2-propanol. A 30 nm thick electron transporting layer was deposited by spray pyrolysis of titanium diisopropoxide bis(acetylacetonate) (Sigma-Aldrich) in 2-propanol (1:15 v/v) at 450 °C. A 1.3M triple cation [(FAPbI₃)_{0.87}(MAPbBr₃)_{0.13}]_{0.92}(CsPbI₃)_{0.08} perovskite precursor with excess PbI₂ (PbI₂:FAI = 1.05:1) was prepared by dissolving FAI (GreatCellSolar), MABr (GreatCellSolar), CsI (ABCR), PbI₂ (TCI), and PbBr₂ (TCI) in DMF and DMSO mixture (0.78:0.22 v/v). Perovskite film was deposited on the prepared substrate by spin-coating the precursor solution at 2000 rpm for 12 s and 5000 rpm for 30 s. Chlorobenzene as an anti-solvent was added 15 s before the end of spin-coating process. Finally, the film was annealed on a hot plate at 100°C for 60 minutes.

*Lead Uptake Experiments:* Using Solutions of dissolved PbI₂: Solutions of known PbI₂ concentration were held at a certain temperature for at least twenty minutes before the addition of the porous uptake material. After waiting a set period of time with minimal agitation, the solution was filtered with a 0.45 µm filter and the resulting filtrate acidified to 2% HNO₃ using concentrated HNO₃.

Using perovskite film: Following decomposition of the perovskite film at 50°C for 1h, the temperature was allowed to stabilize for at least 10 min and the porous uptake material was added. The submerged cell was then kept at the desired temperature with minimal agitation until the suspension was decanted from the substrate, filtered using a 0.45µm filter, and the filtrate acidified to 2% HNO₃ using concentrated HNO₃.

The propensity for the polymer-MOF composite material to take up Pb from simulated perovskite solar cell extracts was tested to determine the optimal conditions for lead uptake (Fig. 1). Using solutions of dissolved PbI₂ in deionized (DI) water allowed us to test many conditions at first, without first fabricating thin films. When using 5 mg composite, >50 % of the lead was taken up from 40 ppm solutions. When the same 40 ppm solution was subjected to two successive treatments of 5 mg, >97% lead was removed (**Figure 2A**). Similarly, when using one treatment of 5 mg followed by one treatment of 2 mg, again more lead was removed than with the single treatment, but the amount removed (95%) was less. When perovskite absorber layers on glass were used instead of a stock PbI₂ solution, results were even more promising (**Fig**. **2B**). With a single treatment of five mg, ∼88% of the lead was removed, and with two five mg treatments of the solution, 99.5% of the lead was removed and with one five mg treatment followed by a two mg treatment, >98% of the lead was removed.

### Example 2: Effect of other materials in perovskite solar cells on Pb absorption

Because perovskite absorber materials contain more materials than just PbI₂, we tested whether it was these other materials that led to increased uptake in the thin film extract samples. In each perovskite film we used, there are methylammonium, formamidinium, and cesium cations as well as iodide and bromide anions. To simulate the conditions found in the dissolved thin film solution, we added methylammonium iodide, formamidinium iodide, and cesium iodide to the PbI₂ solution in the same molar ratio as was found in the perovskite thin films and tested the effect on lead uptake (**Fig. 2C**). Remarkably, lead removal increased with the addition of each material, which supported the conclusions of Fig. 2B, that is, that Pb in the perovskite absorber layers is more favored than Pb from dissolved PbI₂ without the other materials from the perovskite. When PbBr2 based perovskite films were used instead, the Pb uptake decreased somewhat, however (**Fig. 2D**).

### Example 3: Determining the kinetics of Pb removal from degraded thin films

Once we had established that the composite could take up Pb efficiently from thin film absorbers, we then moved to understanding the kinetics of Pb removal from degraded thin films. We performed time dependent lead uptake trials of aqueous PbI₂ solutions at different temperatures using a single 5 mg treatment, from 4°C to room temperature (rt, 22°C) to 50°C (**Figure 3A**). The adsorption was adequately modeled using a pseudo-first order exponential decay function, which indicated a single diffusion-controlled adsorption/desorption event sufficiently described the Pb uptake (**Figure 4**). In each temperature trial, the majority of the lead removal happened within <2 min, and the fastest and most consistent removal event occurred at rt. Because rainfall happens at temperatures much closer to 22°C than 50°C, this result was encouraging and indicated that the dwell time required for uptake of the lead in the contaminated water was relatively short. Performing the same kinetics experiment at 22°C using solutions derived from perovskite thin films resulted in the fastest, highest magnitude, statistically less variable removal. With an understanding of the Pb uptake rate of perovskite-derived solutions, we turned to optimizing the uptake protocol.

After establishing the amount of time needed to reach equilibrium (at least four minutes), we further investigated how increasing mass and number of treatments affected Pb removal (**Figure 3B****, Table 1**). Generally, increasing the amount of polymer-MOF composite improved Pb uptake. However, as in the kinetics study, the amount of Pb taken up quickly reached an equilibrium value (59.8 ± 4.12 % Pb remaining for one 5 mg treatment), followed by less efficient uptake with higher mass treatments (21.56 ± 0.674 % Pb remaining for one 10 mg treatment, 14.9 ± 0.703 % Pb remaining for one 15 mg treatment, 7.33 ± 0.585 % Pb remaining for one 20 mg treatment). Because this experiment used a short amount of time (5 min), diffusion was expected to limit uptake when using a single treatment.

**Table 1.^{a} Pb uptake study of aqueous PbI₂ solutions with varying mass and number of treatments of the polymer-MOF composite.**

| Entry | No. of Treatments | Mass Composite Used (mg) | Pb remaining (%) | [Pb] detected (ppm) | Δ(% Pb) |
|---|---|---|---|---|---|
| 1 | 1 | 5 | 59.8 ± 4.12 | 19.53 ± 1.34 | 40.2 |
| 2 | 2 | 5 | 29.2 ± 2.00 | 9.52 ± 0.653 | 48.8 |
| 3 | 3 | 5 | 9.17 ± 2.22 | 2.99 ± 0.726 | 31.4 |
| 4 | 1 | 10 | 21.6 ± 0.673 | 7.03 ± 0.220 | 78.4 |
| 5 | 2 | 10 | 2.07 ± 0.157 | 0.679 ± 0.051 | 9.58 |
| 6 | 3 | 10 | 0.154 ± 0.020 | 0.050 ± 0.007 | 7.44 |
| 7 | 3^{b} | 10 | 0.040 ± 0.018 | 0.041 ± 0.019 | ND |
| 8 | 3^{c} | 10 | 0.132 ± 0.036 | 0.024 ± 0.007 | ND |
| 9 | 1 | 15 | 14.9 ± 0.703 | 4.87 ± 1.93 | 85.1 |
| 10 | 2 | 15 | 0.876 ± 0.264 | 0.286 ± 0.086 | 5.88 |
| 11 | 3 | 15 | 0.038 ± 0.006 | 0.012 ± 0.002 | 4.34 |
| 12 | 3^{b} | 15 | 0.010 ± 0.002 | 0.010 ± 0.002 | ND |
| 13 | 3^{c} | 15 | 0.047 ± 0.001 | 0.009 ± 0.001 | ND |
| 14 | 1 | 20 | 7.33 ± 0.585 | 2.40 ± 0.191 | 92.7 |
| 15 | 2 | 20 | 0.556 ± 0.139 | 0.182 ± 0.045 | 7.59 |
| 16 | 3 | 20 | 0.024 ± 0.005 | 0.008 ± 0.002 | 4.32 |
| 17 | 3^{b} | 20 | 0.010 ± 0.002 | 0.010 ± 0.002 | ND |
| 18 | 3^{c} | 20 | 0.004 ± 0.043 | 0.008 ± 0.004 | ND |
| 19 | 1 | 30 | 4.52 ± 0.186 | 1.48 ± 0.061 | 95.5 |
| 20 | 1 | 45 | 3.20 ± 0.718 | 1.05 ± 0.235 | 96.8 |
| 21 | 1 | 60 | 2.42 ± 0.294 | 0.791 ± 0.096 | 97.6 |

| | | | | | |
|---|---|---|---|---|---|
| a: Uptake measured after 5 min treatment at 295K. Each data point is the average of three experimental data points and each experimental data point is the average of three replicate measurements. Error bars are included for each plotted point and represent one standard deviation. ND = not determined. b: Solution resulted from digestion of 1.35 cm x 2.35 cm perovskite thin film degraded with 5 mL DI water at 323K for 1h. c: Solution resulted from digestion of 1.35 cm x 2.35 cm perovskite solar cell degraded with 5 mL DI water at 323K for 1h. | | | | | |

We were pleased to observe that double treatment of 10 mg led to greater uptake, and double treatment of 20 mg removed ∼99.5% of the initial Pb (0.182 ± 0.045 ppm). Triple treatment of 10 mg led to > 99.8% reduction, and triple treatment of 15 mg yielded a Pb concentration that was less than the EPA mandated 0.015 ppm value for safe drinking water (0.013 ± 0.002 ppm, 30 ppm starting concentration and 5 mL sample volume, **Table 2**). Using 20 mg triple treatment also reduced the Pb concentration below the 0.015 ppm level (0.008 ± 0.002). When using solutions obtained from perovskite thin film or complete solar cell degradation (3.17 cm² substrate area, -600-700 nm absorber thickness), three treatments of 15 mg or 20 mg composite resulted in >99.8% Pb uptake (5 mL sample volume) to yield a Pb concentration that was below the EPA threshold of 0.015 ppm (0.010 ppm for thin films, 0.008 ppm for complete cells using 15 and 20 mg triple treatment). These data clearly indicate that this MOF/polymer material holds great potential for the sequestration of perovskite-derived Pb, and could render safe perovskite solar cells in the case of catastrophic device failure.

**Table 2: Lead uptake data for solutions brought to safe drinking levels by MOF/polymer composite.^{b}**

| Treatment condition | Pb Source | Time per treatment | Initial [Pb] (ppm) | Final [Pb] (ppm) |
|---|---|---|---|---|
| 15 mg, 3x | PbI₂ stock | 4 min | 32.65 ± 0.122 | 0.012 ± 0.002 |
| 15 mg, 3x | Thin Film | 4 min | 33.46 ± 3.18 | 0.010 ± 0.002 |
| 15 mg, 3x | Solar Cell | 4 min | 18.46 ± 3.09 | 0.009 ± 0.001 |
| 20 mg, 3x | PbI₂ stock | 4 min | 32.65 ± 0.122 | 0.008 ± 0.002 |
| 20 mg, 3x | Thin Film | 4 min | 33.46 ± 3.18 | 0.010 ± 0.002 |
| 20 mg, 3x | Solar Cell | 4 min | 18.46 ± 3.09 | 0.008 ± 0.004 |

| | | | | |
|---|---|---|---|---|
| b: Solutions filtered and acidified after 5 min at 295K and minimal solution agitation. Each data point is the average of three experimental data points and each experimental data point is the average of three replicate measurements. | | | | |

After investigating the adsorption rate and optimized the treatment procedure, we investigated how pH could affect Pb uptake as well as the degree of desorption in neutral water. We observed that Pb uptake from stock solutions of PbI₂ with one treatment of 10 mg was more efficient at pH values between 6-3 (<20% Pb remaining in each case, compared with 21.5% for pH = 7, **Figure 3C**). At pH = 2, very little Pb was adsorbed due to decomposition of the composite. When solutions derived from perovskite thin films were used instead of the PbI₂ stock solution, similar adsorption was observed, which indicated that pH values between 4 and 6 (rainwater pH values vary from pH 4.1 - 6.8)^{18,19} could be beneficial for Pb uptake. To test the degree of Pb desorption, we first performed adsorption experiments at 295K, isolated the polymer-MOF composite, added fresh DI H₂O, and measured the Pb concentration after two hours at different temperatures (**Figure 3D****, Table 3**). At 273K, 2.71 ± 0.059 % of the adsorbed Pb had leached from the composite, at 295K -3.17 ± 0.26 %, and at 323K 2.08 ± 0.25% of the originally adsorbed Pb had leached back into solution. This result indicated that the polymer-MOF composite leached little Pb back into solution after uptake.

**Table 3. Pb Adsorption and Desorption Study Data**

| Entry | Temp. (K) | Mass (g) Composite | Pb adsorbed/*desorbed* (%) | [Pb] adsorbed/*desorbed* (ppm) |
|---|---|---|---|---|
| Pb adsorption | 295 | 15 | 91.8 ± 0.97 | 34.01 ± 0.338 |
| Pb *desorption* | 273 | 15 | *2.95 ± 0.060* | *0.943 ± 0.021* |
| Pb *desorption* | 295 | 15 | *3.18 ± 0.260* | *1.02 ± 0.091* |
| Pb *desorption* | 323 | 15 | *2.08 ± 0.247* | *0.667 ± 0.086* |

### Example 4: Effect of field conditions on Pb absorption

After understanding the degree of Pb desorption from the material, we used accelerated aging to investigate how field conditions could affect Pb absorption (**Figure 5**). Irradiating the composite powder with one sun for 18h while allowing the powder to warm to 60°C during irradiation did not affect Pb uptake after 5 min treatment with 15 mg (8.40 ± 0.711 % Pb remaining after light aging, 8.2 ± 0.97% Pb without aging). Heating the powder to an excessive 100°C for 18 h (22.7 ± 1.53 % Pb remaining) or heating the sample to 100°C for 18h followed by light aging for 18h at 60°C (43.67 ± 3.09 % Pb remaining) both resulted in reduced uptake activity. This data indicated that at temperatures possibly encountered in the field (60°C)²⁰ with sunlight, the composite could still function as well as samples without aging, but unrealistically high temperatures (100°C) by themselves or with successive light aging could reduce adsorption capability.

### Example 5: Exposure of solar cell modules to stagnating and flowing water

Once we optimized the treatment conditions for small cells and films, we ventured to extend the treatments to module-sized substrates. Using degraded monolithic series cell modules with an area of 45.5 cm², we compared Pb leaching under two types of conditions: total submersion with water and flow-through of water during extended heavy rain. The treatments were scaled linearly from three 15 mg treatments for 3.17 cm² substrates to three 300 mg treatments for a 45.5 cm² substrate. Because the nature of the device failure is different, the concentrations resulting from each failure are expected to be different. **Figure 6** shows the modules tested.

*Module-Scale Pb Uptake: Submersion:* A 45.5 cm² perovskite solar cell module was fixed to a 10 cm x 10 cm glass sheet using two-sided scotch tape. Three sachets of 300 mg polymer-MOF composite were placed around the module and butylene rubber was added to each side. Separately, a second 10 cm x 10 cm glass sheet with butylene rubber on three sides was warmed to 150°C for 5 minutes. The warmed sheet was gently pressed against the other to make contact between the rubber sections and then the previously cool glass sheet was placed on a hot plate set to 150°C for five minutes. Gentle pressing on the top of the partially encapsulated module ensured the butylene rubber was sealed well on all sides. After cooling to room temperature, DI water was added until the module and sachets were completely submerged. Each day, an aliquot was taken, acidified to 2% HNO₃ using concentrated HNO₃ and analyzed using ICP-OES.

*Flow-Through*: A 45.5 cm² perovskite solar cell module was fixed to a 7 cm x 10 cm glass sheet using butylene rubber. Three sachets of 300 mg polymer-MOF composite were placed beneath the module and butylene rubber was added to the longer sides of the module. Separately, a second 7 cm x 10 cm glass sheet with butylene rubber on the longer sides was warmed to 150°C for 5 minutes. The warmed sheet was gently pressed against the other to make contact between the rubber sections and then the previously cool glass sheet was placed on a hot plate set to 150°C for five minutes. Gentle pressing on the top of the partially encapsulated module ensured the butylene rubber was sealed well on all sides. After cooling to room temperature, DI water was through the module from the top (side without sachets) at a rate of 37 mL/hr and fractions taken every 12 minutes. During the treatment, the substrate was stationary and fixed at a 60° angle and the droplet placement was randomized. Each droplet flowed through the module was observed to be in contact with the solar cell for approximately 5 s, and in contact with the MOF underneath the solar cell for -25 s before dropping into the collection vial. The fractions were then acidified to 2% HNO₃ using concentrated HNO₃ and analyzed using ICP-OES.

In the first type of failure, submersion, a hole in the top front panel causes water to enter, become trapped, and eventually submerge the module inside its case. To test Pb leaching resulting from submersion, we encapsulated a module on three sides with 300 mg of polymer-MOF composite in a water-permeable paper sachet on each closed side. DI water was added to submerge the module and aliquots were taken each day. Within seconds, the black portion of the perovskite absorber in contact with the water turned yellow (**Figure 6**, left photograph), while the perovskite absorber layer underneath the Au cathode stayed black overnight. After 24h, all of the black perovskite film was visibly degraded to a yellow color, and most of the absorber layer in contact with the water appeared to be dissolved. This yellow color persisted for the week of sampling. As the time allowed for the for uptake increased from 24h to 168h, the amount of lead taken up by the polymer-MOF composite continually increased (**Figure 7**). During sampling at 72h, the module was dropped accidentally from a height of around 6 cm, which did not result in damage to the sample, but did result in agitation of the solution. Nevertheless, the amount of Pb detected in the solution decreased from ∼3% at 72h to -1% at 168h.

In the second type of failure, leakage, water not only enters the cell, but a hole in the bottom allows water to exit the cell, ostensibly after extracting some of the perovskite absorber layer. While there could be many versions of this failure with varying degrees of severity, we chose to construct the worst-case scenario, where the top and bottom of the encapsulating box is completely open, allowing water maximum contact time with the perovskite module and unimpeded flow-through (**Figure 6****,** right photograph). In this scenario, simulated moderate rainfall (0.76 mm/h) was flowed directly into the open top of the module (37 mL/h for 45.5 cm² substrate area), and 7-8 mL fractions were collected every 12 minutes for an hour. Before collection, the water was forced to flow through three separate quantities of 300 mg polymer-MOF composite in water-permeable paper sachets fixed below the device. Total Pb dissolution of the 39 cm² perovskite film in 8 mL of H₂O would yield 738 ppm theoretically, but the percent of Pb detected in the collected fractions was much lower (<0.5% Theoretical Maximum, **Figure 8**).

During the hour-long simulated rainfall, the amount of Pb present in each fraction (6-8 mL) was low, with each 12 min fraction containing less than 0.4% of the theoretical maximum value. Concentrations increased from 1.78 ppm for the first twelve-minute fraction to a maximum of 2.66 ppm for the 24-36 min fraction and then decreased to 2.38 ppm in the 48-60 min fraction. After this treatment, four days were allowed to pass to simulate drying between rainfall events, and another simulated rainfall treatment performed on the fifth day. During this treatment, much lower Pb concentrations were observed in each of the twelve-minute fractions, and each successive fraction (from 0.55 ppm for 0-12 min to 0.07 ppm for 48-60 min) contained less Pb than the last. While these values are higher than the EPA limit, the amount of Pb leached at this scale (45.5 cm² substrate, <0.4% % for the first day and < 0.1% for the fifth day, three treatments of 300 mg) was similar to small scale experiments (3.17cm² substrate, <0.1% for three treatments of 15 and 20 mg).

### Example 6: Identification of moieties responsible for lead adsorption

Finally, we performed X-ray Photoelectron Spectroscopy (XPS) on powder samples of composite material with and without adsorbed Lead in an effort to identify which moieties in the poly(dopamine) material were responsible for adsorption. Dopamine oxidation produces oligomers with a random distribution of several functional groups and linkages between units.^{21,2223} Representative spectra of the O 1s, N 1s, and Pb 4f regions were obtained and shown in **Figure 9 A-C****.** For the MOF/polymer without adsorbed Pb, the N 1s region indicated the presence of at least two major species: one resembling an indoline group with binding energy near 400 eV, one resembling an amine group binding energy near 402 eV, and a minor component resembling an indole group binding energy near 399 eV (**Figure 9a**). Similarly, the O 1s region indicated a mixture of catechol and quinone, with majority quinone species present (**Figure 9b**). For the polymer without adsorbed Pb, the major species present was the indole, with a minority of indoline groups present, but none or very little amine groups detected (**Figure 9a**). In the O 1s region, the catechol groups were the majority, instead of the quinone **(****Figure 9b**). This finding clearly shows that dopamine polymerization on the surface and through the pores of the MOF leads to a very different distribution of functional groups throughout the polymer.

Before Pb adsorption, no Pb was detected in the Pb 4f region of either material (**Figure 9c**). After Pb adsorption, a doublet appeared and was ascribed to Pb²⁺ bound to catechol (polymer) or amine (MOF/polymer). In the MOF/polymer material, Pb adsorption was also accompanied by an increase in the signal intensity and slight shift in the binding energy for the amine and catechol functional group signals, along with a decrease and shift in the indoline and quinone functional group signals. In the polymer material, each signal's intensity was reduced, but the catechol signal shifted towards lower binding energy. These data led us to propose the following mechanism of adsorption (**Figure 9d**): In the MOF/polymer material, upon contact with Pb²⁺ contaminated water the amine and catechol functional groups were responsible for Pb chelation, but in the polymer without MOF there was very little if any amine present, so catechol was the primary chelating group.

### Conclusions

We have investigated the propensity for a polymer-MOF composite to act as a Pb uptake material specifically for hybrid organic-inorganic Pb halide perovskite materials. We studied the kinetics of Pb uptake and found that the cations other than Pb present in the perovskite film increased uptake, while the Br anions decreased Pb uptake. We optimized the treatments required to lower the Pb concentration resulting from a fully dissolved 3.17 cm² perovskite absorber layer to below the EPA limit for safe drinking water and successfully scaled up the optimized treatment protocol to a 45.5 cm² monolithic series cell. We also investigated Pb desorption from the composite and found very little Pb leached back into solution once adsorbed in a range of temperatures. We found that acid rain (rain pH <5.6) and light soaking at 60°C did not appreciably lower uptake activity, and proposed an adsorption mechanism where catechol and amine functional groups were mainly responsible for Pb chelation in the polymeric material. After demonstrating the efficacy of this material for perovskite-originating Pb, we believe it could be used in field-wide application as a "Safe-by-Design" strategy for mitigating any detrimental environment impact that could be foreseen from industrialization of perovskite solar cells.

### References

(1) Kojima, A.; Teshima, K.; Shirai, Y.; Miyasaka, T. Organometal Halide Perovskites as Visible-Light Sensitizers for Photovoltaic Cells. J. Am. Chem. Soc. 2009, 131, 17, 6050-6051.
(2) NREL. Best Research Cell Efficiencies http://www.nrel.gov/ncpv/, http://www.nrel.gov/ncpv/images/efficiency_chart.jpg.
(3) Jena, A. K.; Kulkarni, A.; Miyasaka, T. Halide Perovskite Photovoltaics: Background, Status, and Future Prospects. Chem. Rev. 2019, 119, 5, 3036-3103.
(4) Kadro, J. M.; Hagfeldt, A. The End-of-Life of Perovskite PV. Joule 2017, 1, 1, 29-46.
(5) Bae, S.-Y.; Lee, S. Y.; Kim, J.; Umh, H. N.; Jeong, J.; Bae, S.; Yi, J.; Kim, Y.; Choi, J. Hazard Potential of Perovskite Solar Cell Technology for Potential Implementation of "Safe-by-Design" Approach. Sci. Rep. 2019, 9, 1, 4242.
(6) Alberola-Borràs, J.-A.; Baker, J. A.; De Rossi, F.; Vidal, R.; Beynon, D.; Hooper, K. E. A.; Watson, T. M.; Mora-Seró, I. Perovskite Photovoltaic Modules: Life Cycle Assessment of Pre-Industrial Production Process. iScience 2018, 9, 542-551.
(7) Ibn-Mohammed, T.; Koh, S. C. L.; Reaney, I. M.; Acquaye, A.; Schileo, G.; Mustapha, K. B.; Greenough, R. Perovskite Solar Cells: An Integrated Hybrid Lifecycle Assessment and Review in Comparison with Other Photovoltaic Technologies. Renew. Sustain. Energy Rev. 2017, 80, 1321-1344.
(8) Song, Z.; Mcelvany, C.; Phillips, A. B.; Celik, I.; Krantz, P.; Watthage, S. C.; Liyanage, G. K.; Apu, D.; Heben, M. A Technoeconomic Analysis of Perovskite Solar Module Manufacturing with Low-Cost Materials and Techniques. Energ Environ. Sci. 2017, 0-22.
(9) Celik, I.; Song, Z.; Phillips, A. B.; Heben, M. J.; Apul, D. Life Cycle Analysis of Metals in Emerging Photovoltaic (PV) Technologies: A Modeling Approach to Estimate Use Phase Leaching. J. Clean. Prod. 2018, 186, 632-639.
(10) Hailegnaw, B.; Kirmayer, S.; Edri, E.; Hodes, G.; Cahen, D. Rain on Methylammonium Lead Iodide Based Perovskites: Possible Environmental Effects of Perovskite Solar Cells. J. Phys. Chem. Lett. 2015, 6, 9, 1543-1547.
(11) van de Poel, I.; Robaey, Z. Safe-by-Design: From Safety to Responsibility. Nanoethics 2017, 11, 3, 297-306.
(12) Chhillar, P.; Dhamaniya, B. P.; Dutta, V.; Pathak, S. K. Recycling of Perovskite Films: Route toward Cost-Efficient and Environment-Friendly Perovskite Technology. ACS Omega 2019, 4, 11880-11887.
(13) Huang, L.; Xu, J.; Sun, X.; Xu, R.; Du, Y.; Ni, J.; Cai, H.; Li, J.; Hu, Z.; Zhang, J. New Films on Old Substrates: Toward Green and Sustainable Energy Production via Recycling of Functional Components from Degraded Perovskite Solar Cells. ACS Sustain. Chem. Eng. 2017, 5, 4, 3261-3269.
(14) Kadro, J. M.; Pellet, N.; Giordano, F.; Ulianov, A.; Müntener, O.; Maier, J.; Grätzel, M.; Hagfeldt, A. Proof-of-Concept for Facile Perovskite Solar Cell Recycling. Energ Environ. Sci. 2016, 9, 10, 3172-3179.
(15) Zhao, Y.; Wei, J.; Li, H.; Yan, Y.; Zhou, W.; Yu, D.; Zhao, Q. A Polymer Scaffold for Self-Healing Perovskite Solar Cells. Nat. Commun. 2016, 7, 10228.
(16) Kim, G.-W.; Kang, G.; Kim, J.; Lee, G.-Y.; Kim, H. Il; Pyeon, L.; Lee, J.; Park, T. Dopant-Free Polymeric Hole Transport Materials for Highly Efficient and Stable Perovskite Solar Cells. Energ Environ. Sci. 2016, 9, 7, 2326-2333.
(17) Sun, D. T.; Peng, L.; Reeder, W. S.; Moosavi, S. M.; Tiana, D.; Britt, D. K.; Oveisi, E.; Queen, W. L. Rapid, Selective Heavy Metal Removal from Water by a Metal-Organic Framework/Polydopamine Composite. ACS Cent. Sci. 2018, 4, 3, 349-356.
(18) Charlson, R. J.; Rodhe, H. Factors Controlling the Acidity of Natural Rainwater. Nature 1982, 295, 5851, 683-685.
(19) Taiwan, C. W. B. of. Yearly Rainfall pH Values.
(20) Du, Y.; Fell, C. J.; Duck, B.; Chen, D.; Liffman, K.; Zhang, Y.; Gu, M.; Zhu, Y. Evaluation of Photovoltaic Panel Temperature in Realistic Scenarios. Energy Convers. Manag. 2016, 108, 60-67.
(21) Zangmeister, R. A.; Morris, T. A.; Tarlov, M. J. Characterization of Polydopamine Thin Films Deposited at Short Times by Autoxidation of Dopamine. Langmuir 2013, 29 , 27, 8619-8628.
(22) Della Vecchia, N. F.; Avolio, R.; Alfè, M.; Errico, M. E.; Napolitano, A.; d'Ischia, M. Building-Block Diversity in Polydopamine Underpins a Multifunctional Eumelanin-Type Platform Tunable Through a Quinone Control Point. Adv. Funct. Mater. 2013, 23, 10, 1331-1340.
(23) Hong, S.; Na, Y. S.; Choi, S.; Song, I. T.; Kim, W. Y.; Lee, H. Non-Covalent Self-Assembly and Covalent Polymerization Co-Contribute to Polydopamine Formation. Adv. Funct. Mater. 2012, 22, 22, 4711-4717.

## Claims

1. A solar cell module comprising one or more solar cells comprising a toxic material, wherein said module is provided with an adsorbent material.

2. The solar cell module of claim 1, wherein said adsorbent material is provided for capturing said toxic material in case of leakage of components of the solar cell out of said solar cell and/or module.

3. The solar cell module of any one of the preceding claims, wherein said solar cell is a perovskite solar cell, preferably an organic-inorganic perovskite solar cell comprising lead, said lead being said toxic material.

4. The solar cell module of any one of the preceding claims, wherein said one or more solar cells are provided in said casing, and wherein said adsorbent material is also provided in said casing.

5. The solar cell module of any one of the preceding claims, wherein said adsorbent material is porous.

6. The solar cell module of any one of the preceding claims, wherein the adsorbent material is selected from the group consisting of: metal organic frameworks (MOFs), MOF/polymer composites, covalent organic frameworks (COFs), carbon, porous polymers, and combinations comprising one or more of the aforementioned.

7. The solar cell module of any one of the preceding claims, wherein said adsorbent material comprises a Metal Oxide Framework/polymer (MOF/polymer) composite material.

8. The solar cell module of claim 7, wherein the polymer of said MOF/polymer comprises one or more of the following chemical functions: alcohol/hydroxyl, catechol, primary, secondary or tertiary amine, amide, nitrile, pyridine, pyrrole, thiol, thiolether, thiophene, thiadiazole, phenol, pyragallol, carboxylic acid, ester, acyl, crown ether, phosphate, phosphoryl, epoxide, halogen, haloalkane.

9. The solar cell module of claim 7 or 8, wherein the polymer of said MOF/polymer comprises and/or is formed from one or more moieties, which are independently selected from moieties of formula (I): 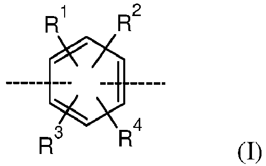 wherein,
the dotted lines represent the two single bonds by which the moiety of formula (I) is connected to a neighbouring moiety of the polymer;
R¹, R², R³ and R³ are independently selected from H, -OH, -NH₂, -NO₂, -COH, -COOH, -CN, from substituents of formula (V) and (VI): 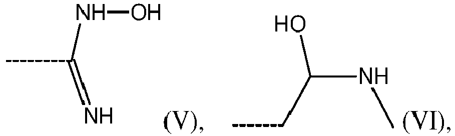
and from organic substituents comprising from 1 to 20 carbons and 0 to 20 heteroatoms selected from O, N, S, P and halogen;
wherein two or three of R¹, R², R³ and R³ may be connected with each other so as to form a ring or ring system fused to the benzene ring of formula (I), said ring or ring system comprising from 2-30 carbons and 0 to 30 heteroatoms;
with the proviso that one or more selected from R¹, R², R³ and R³ are independently selected from substituents of formula (II): 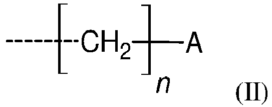 wherein:
the dotted lines in formulae (II), (V) and (VI) represent the single bond by which the respective substituent of formula (II), (V) and/or (VI) is connected to the benzene ring of formula (I),
A is independently selected from -OH, -NH₂, and -SH,
n is 0 or an integer of 1-10.

10. The solar cell module of any one of the preceding claims, wherein the polymer of said MOF/polymer comprises one or more moieties, which are independently selected from moieties of formula (III): 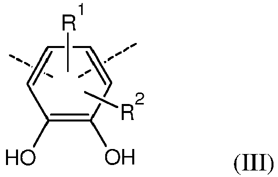 wherein:
said dotted lines, R¹ and R² are independently defined as in claim 7.

11. The solar cell module of any one of claims 7-10, wherein the polymer comprises and/or is formed from one or more of the following monomeric moieties: dopamine (DA), serotonin (S), 2-aminophenol (oAP), 3-aminophenol (mAP), 4-aminophenol (pAP), p-phenylenediamine (pPDA), o-phenylenediamine (oPDA), 3,4-dihydroxybenzoic acid (3,4-DHBA), 3,4-dihydroxyphenylacetic acid (3,4-DHPAA), 3,4-dihydroxyhydrocinnamic acid (3,4-DHHCA), 3,4-dihydroxybenzonitrile (3,4-DHBN), 4-nitrocatechol (3-NC), 3,4-dihydroxybenzaldehyde(3,4-DHBAH), 2,3,5-trihydrixybenzaldehyde (2,3,5-THBA), 217 3,4-dihydroxybenzylamine (3,4-DHBAM), 3,4-dihydroxybenzamidoxime (3,4-DHBAMX), (+)epinephrine (Adrenaline), Tetracyanoquinodimethane (TCNQ), viologens, Tetrathiafulvalene (TTF), quinone (Q), hydroquinone (HQ), tyramine (TA), vinylferrocene (VF or VFc), perfluorinated Sulfonic acids (Nafion®), styrene sulfonate (SS), 4-vinylpyridine (VP), aniline (ANI), aniline derivatives, 1 -aminoanthracene, o-toluidine, 1 ,8-diaminonaphthalene (DAN), aniline-co-N- propanesulfonic acid-aniline, diphenylamine (DPA), 2-aminodiphenylamine (2ADPA), luminol (L), pyrrole (P) and P derivatives, indole and derivatives, melatonin (M), indoline, carbazole (Cz), thiophene (T) and T derivatives, azines, 1 -Hydroxyphenazine (PhOH), acridine red (AR), phenosafranin (PhS), flavin (FI), new Fuchsin (nF), fluorene (F), 9-Fluorenone (FO), 9,10-dihydrophenanthrene, p-phenylene (PP), phenylenevinylene (PPV), triphenylamine (TPA), 4-vinyl-triphenylamine (VTPA), polyrhodanine (Rh), Eriochrome Black T, 5-amino-1,4-naphthoquinone (ANQ), 5-amino-1-naphthol, 4-ferrocenylmethylidene-4H-cyclopenta-[2,1-b;3,4-b°]-dithiophene, fullerene-functionalized terthiophene (TTh-BB), tetra-substituted porphyrins, phtalocyanines, tetra-substituted-phtalocyanines, 4,4°(5°)-bis(3,4-ethylenedioxy)thien-2-yl, tetrathiafulvalene (EDOT-TTF), {3-[7-Oxa-8-(4-tetrathiafulvalenyl)octyl]-2,2°-bithiophene} (T-TTF), aniline-co-diaminodiphenyl sulfone, aniline-co-2,3-amino or 2,5-diamino benzenesulfonic acid, aniline-co-o-aminophenol, m-toluidine-co-o-phenylenediamine, luminol-aniline, and 2,5-dihydroxy- 1,4-benzenediacetic acid (DHAA).

12. The solar cell module of any one of claims 7-11, wherein said polymer comprises polydopamine (PDA).

13. The solar cell module of any one of the preceding claims, wherein said adsorbent material comprises one or more selected from the group consisting of: a metal-organic framework (MOF) and a MOF/polymer, wherein said MOF is selected from the group consisting of: Fe-BTC (BTC = 1,3,5-benzenetricarboxylate), Cu-BTC, Cu-TDPAT (TDPAT = 2,4,6-tris(3,5-dicarboxylphenylamino)-1,3,5-triazine) or AI-BDC-NH₂, (BDC = 2-amino-1,4-benzenedicarboxylate), Zr-BDPC (BDPC = 4,4-benzenebiphenyldicarboxylic acid), Zr-PCN-221 (Zr-porphyrin), MIL-127 Fe (MIL-127 = 3,3',5,5'-azobenzenetetracarboxylate).

14. The solar cell module of any one of the preceding claims, wherein said adsorbent material comprises Fe-BTC/PDA.

15. A method for producing a solar cell module comprising one or more solar cells comprising a toxic material, wherein said method comprises: providing with an adsorbent material when assembling said solar cell module.

16. The use of adsorbent materials for preventing and/or reducing leakage of toxic materials from solar cells comprising such toxic materials.
